# DEMANDE DE BREVET EUROPEEN

(11) **EP 1 093 159 A1**
(43) Date de publication de la demande: **18.04.2001**
(21) Numéro de dépôt: 00402796.7
(22) Date de dépôt: 10.10.2000
(51) Int. Cl.: H01L 21/56, H03H 3/08

(54) **Procédé d'encapsulation de composants électroniques**

(30) Priorité: 15.10.1999 FR 9912916
(71) Demandeur: THOMSON-CSF, 75008 Paris (FR)
(72) Inventeur: Bureau, Jean-Marc, 94117 Arcueil Cedex (FR); Elziere, Jacques, 94117 Arcueil Cedex (FR); Le Bail, Daniel, 94117 Arcueil Cedex (FR); LeLong, Christian, 94117 Arcueil Cedex (FR); Nguyen, Ngoc-Tuan, 94117 Arcueil Cedex (FR)

(57) **Abrégé**

L'invention concerne un procédé d'encapsulation de composants électroniques comprenant les étapes suivantes :
- Le report d'au moins un composant électronique (10) côté face active sur une embase (20), ladite embase comportant sur une première face des contacts électriques (101, 102, 107), sur une seconde face des plots de connexions (201, 202), et comportant une première série de vias (301, 302) reliant les contacts électriques et les plots de connexion et une série de trous (50).
- Le dépôt d'un film déformable (40) sur la face opposée à la face active du ou des composants électroniques.
- L'aspiration du film déformable, au travers de la série de trous (50) depuis la seconde face de l'embase, de manière à envelopper le ou lesdits composants électroniques.

Le procédé peut comprendre en outre au-dessus du film déformable, un dépôt minéral pour assurer l'herméticité des composants et un dépôt conducteur pour assurer le blindage.

Applications : filtres à ondes acoustiques de surface.

## Description

La présente invention concerne l'encapsulation de composants électroniques, en particulier de composants dont la surface doit être libre tels les filtres à ondes acoustiques de surface (SAW), les composants RF, les capteurs et plus précisément le procédé de réalisation d'une telle encapsulation.

Les composants à ondes de surface (COS) utilisés dans le domaine électronique notamment comme filtres dans les domaines radio fréquences ou fréquences intermédiaires dans le but de sélectionner des bandes de fréquences dans la téléphonie mobile, utilisent le principe de la génération et de la propagation d'ondes acoustiques à la surface d'un substrat piézoélectrique. Cette fonctionnalité nécessite de ménager un espace libre à la surface du composant où se propagent les ondes acoustiques. Ainsi les procédés classiques de protection des composants à ondes acoustiques de surface utilisent des boîtiers céramiques ou métalliques scellés hermétiquement. Cependant ces procédés sont coûteux et peu productifs, et rendent difficiles la miniaturisation des composants.

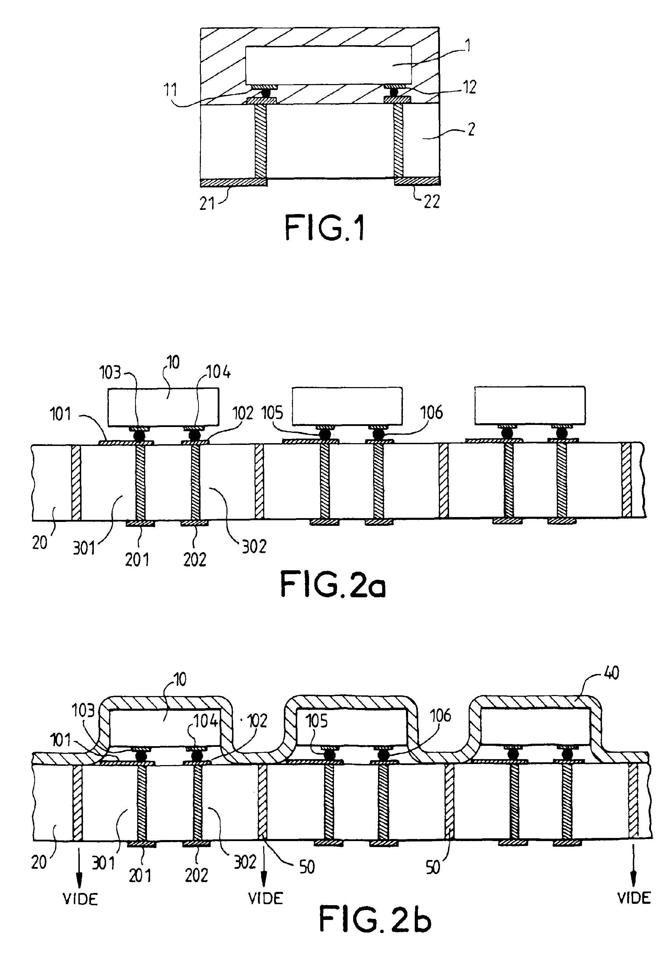

Dans le domaine des composants à semi-conducteur, les technologies d'assemblage dites CSP (pour Chip-size ou Chip-scale Package c'est-à-dire encapsulation à la taille ou à l'échelle de la puce) permettent un haut degré de miniaturisation. Celle qui présente actuellement le plus d'intérêt en termes de degré de miniaturisation et de coût est basée sur un report flip-chip (technique de la puce retournée connue de l'homme de l'art) comme illustré en Figure 1.

Plus précisément un composant à semi-conducteur 1 est relié à une embase 2 par l'intermédiaire de contacts 11 et 12 de type « flip-chip ». Des plots électriques 21 et 22 permettent de connecter l'ensemble du composant 1 à des circuits extérieurs par des métallisations internes et des vias au travers de l'embase. Une résine d'encapsulation 3 vient consolider l'assemblage mécanique et assurer une protection du composant.

Cependant ce procédé n'est pas directement applicable aux composants à ondes de surface : la résine de surmoulage remplit l'interstice entre le composant et le substrat, ce qui perturbe la propagation des ondes acoustiques de surface. D'autre part, la surface active n'étant pas passivée contrairement aux composants à semi-conducteurs, la résine seule ne constitue pas une barrière suffisante vis-à-vis d'agressions extérieures, telle que l'humidité.

Dans le domaine plus particulier des filtres à ondes de surface, la Société Siemens Matsushita Components GmbH a proposé de réaliser l'encapsulation des composants par la fabrication d'une enveloppe formant des capots qui entourent les puces et qui reposent sur le substrat dans les zones entre les puces (WO 99/43084). Les capots peuvent être obtenus à partir d'une feuille métallique fixée sur une trame soudable du substrat, ou d'une feuille plastique collée sur le substrat entre les puces. Dans le cas d'une feuille plastique, même métallisée, la protection n'est pas hermétique ni parfaitement blindée.

La présente invention propose d'envelopper collectivement les puces à l'aide d'un film plastique déformable qui va adhérer sur le dos et sur les côtés des puces ainsi que sur le substrat. Ce procédé a l'avantage de renforcer la tenue mécanique de la puce sur le substrat. Il a également l'avantage de permettre, après une étape d'élimination locale du film décrite ci-dessous, de présenter une structure sur laquelle on pourra aisément réaliser un dépôt minéral continu permettant de rendre parfaitement étanche la structure. Enfin, si le dépôt minéral est choisi métallique, on réalise un blindage électromagnétique continu pouvant être en contact direct avec la masse électrique sur le substrat.

Le film déformable, adhérant sur la face arrière et les faces latérales des puces, ainsi que sur le substrat entre les puces, forme un assemblage monolithique de bonne tenue mécanique.

Plus précisément l'invention a pour objet un procédé d'encapsulation de composant électronique caractérisé en ce qu'il comprend les étapes suivantes.
- Le report d'au moins un composant électronique côté face active sur une embase, ladite embase comportant sur une première face des contacts électriques, sur une seconde face des plots de connexions et comportant une série de vias reliant les contacts électriques et les plots de connexion et une série de trous.
- Le dépôt d'un film déformable sur la face opposée à la face active du ou des composants électroniques.
- L'aspiration du film déformable, au travers de la série de trous depuis la seconde face de l'embase, de manière à envelopper le ou lesdits composants électroniques, et mettre en contact avec le film déformable, ces derniers, de manière à former un assemblage solide.

Selon une variante de l'invention, le procédé de l'invention peut comprendre en outre une étape d'élimination locale du film sur le substrat dans la zone entre les puces permettant au dépôt minéral d'envelopper totalement le composant et assurer ainsi une parfaite herméticité. Dans le cas d'un dépôt métallique, cette étape permet également de reprendre un contact électrique de masse sur le substrat et d'assurer ainsi un blindage électromagnétique efficace.

L'invention a aussi pour objet un procédé de fabrication collective de composants électroniques encapsulés comprenant les étapes suivantes.
- Le report collectif de composants électroniques côté face active sur une embase, ladite embase comportant sur une première face des contacts électriques, sur une seconde face des plots de connexions et comportant une série de vias reliant les contacts électriques et les plots de connexion et une série de trous.
- Le dépôt d'un film déformable sur l'ensemble des faces opposées aux faces actives des composants électroniques.
- L'aspiration du film déformable, au travers de la série de trous depuis la seconde face de l'embase, de manière à envelopper lesdits composants.
- Le dépôt d'une résine d'encapsulation sur le film déformable de manière à assurer la protection hermétique des composants électroniques.
- La découpe de l'ensemble résine/film déformable/embase de manière à individualiser les composants électroniques encapsulés.

Selon une variante de l'invention le ou les composants sont des dispositifs à ondes de surface.

Avantageusement l'aspiration du film déformable est couplée à une étape de chauffage et/ou à l'application d'une pression à la surface du film souple.

Selon une variante de l'invention, le procédé d'encapsulation comprend en outre un dépôt minéral pour assurer l'herméticité, au-dessus du film déformable.

Avantageusement le procédé d'encapsulation peut également comprendre un dépôt conducteur au-dessus du film déformable pour assurer le blindage des composants.

Le procédé d'encapsulation peut également comprendre le dépôt d'un second film déformable (pouvant être identique au premier film déformable) au-dessus du dépôt conducteur. Il peut avantageusement s'agir d'un film polymère chargé de particules minérales conductrices. Ce second film peut ainsi remplacer la résine classique d'encapsulation en contact avec l'extérieur.

L'invention sera mieux comprise et d'autres avantages apparaîtront à la lecture de la description qui va suivre donnée à titre non limitatif et grâce aux figures annexées parmi lesquelles :
- La Figure 1 illustre un exemple de composant encapsulé selon l'art connu.
- Les Figures 2a à 2b illustrent les étapes d'un procédé d'encapsulation selon l'invention.
- Les Figures 3a et 3b illustrent une étape d'un procédé d'encapsulation selon l'invention comprenant la reprise de contact électrique par gravure du film déformable.
- Les Figures 4a et 4b illustrent une étape de protection finale des composants préalablement enrobés par le film souple, par une résine épaisse, et la découpe d'individualisation des composants.
- La figure 5 illustre une étape de protection finale à l'aide d'un second film souple.

Nous allons décrire un procédé de fabrication collective de composants électroniques encapsulés particulièrement adapté dans le cas de composants à ondes acoustiques de surface pour lesquels il est impératif de préserver un espace libre pour la propagation des ondes acoustiques.

Le procédé de fabrication comporte une première étape illustrée en Figure 2a dans laquelle les composants 10 sont reportés collectivement sur une plaque 20. Cette plaque comporte les plots de connexion 201 et 202 sur une de ses faces dite face extérieure et des plots de connexion 101 et 102 sur la face opposée à la face extérieure. Ces derniers plots 101 et 102 permettent de connecter à l'extérieur les contacts électriques 103 et 104 des composants 10 par report de type « flip-chip » par l'intermédiaire de premiers vias conducteurs 301, 302 et d'éléments conducteurs intermédiaires 105, 106. Ces éléments conducteurs intermédiaires peuvent être des billes métalliques en or ou être des billes de soudures. L'opération de contact électrique peut être faite par thermocompression, collage ou soudure par ultrasons.

Une seconde étape consiste à déposer un film déformable 40 sur l'ensemble des composants comme illustré en Figure 2b. Par aspiration au travers d'une série de trous 50 réalisés dans la plaque 20, ce film se conforme en enveloppant les composants. Il peut s'agir par exemple d'un film plastique déformable. L'opération d'aspiration peut avantageusement être combinée à une opération de chauffage et/ou à l'application d'une pression à la surface du film pour améliorer sa déformation. Typiquement l'opération d'aspiration peut être réalisée dans un autoclave sous vide. Le film déformable est de préférence un film très mince pouvant avoir une épaisseur de l'ordre d'une centaine de microns. Pour ce faire, on peut avantageusement utiliser un adhésif déposé préalablement sur l'ensemble de la face du film dirigé vers les composants, ou sur tout ou partie de la plaque. On peut également utiliser un film qui présente des propriétés de thermo-adhérence (film thermoplastique) pouvant être mis en oeuvre par l'effet de la température et de la pression. Il peut notamment s'agir de Pyralux de Du Pont, d'Ablefilm de Ablestik ou Staystick de Apha Metals. De façon opérationnelle, ce film peut être conducteur. Notamment il peut s'agir d'un polymère chargé de particules conductrices, ou d'un film métallisé sur une de ses faces. Il peut en outre être composé de plusieurs couches de manière à en combiner les propriétés de chacune d'entre elles. Par exemple il est possible d'utiliser une couche conductrice ou une couche minérale présentant des propriétés de barrière d'humidité, chacune des couches étant de très faibles épaisseurs de quelques dixièmes de microns à quelques microns.

La couche minérale peut être de type SiO₂, SiN, déposée sous vide par pulvérisation ou plasma. Il est également possible de déposer une couche organique de type parylène pour assurer une protection contre l'humidité.

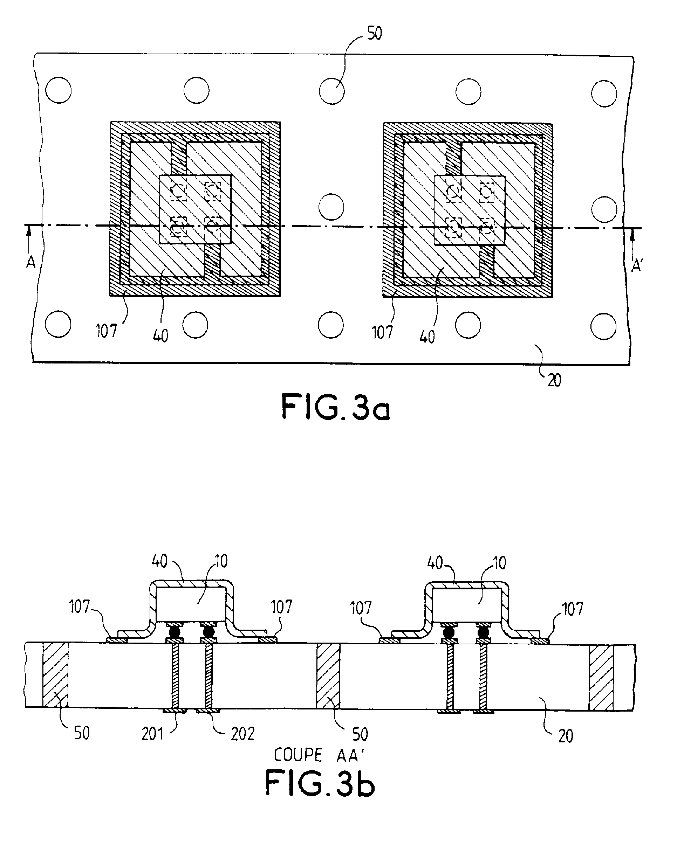

L'intérêt d'utiliser notamment une couche conductrice est d'assurer un blindage électromagnétique du composant. Si cette couche doit être reliée à la masse, on peut avantageusement réaliser préalablement une gravure dans le film déformable 40 afin de dégager une plage conductrice correspondant à un plot de masse de l'embase. Cette ouverture peut être réalisée par exemple par perçage laser ou mécanique (découpe partielle à la scie). Plus précisément la Figure 3a illustre une vue de dessus de l'embase comprenant les trous 50, par lesquels l'aspiration vient plaquer le film déformable sur l'embase. Des anneaux de masse 107 correspondent aux plots de masse illustrés sur la coupe selon l'axe AA' de la Figure 3b. Le film déformable 40 est gravé sur une partie de l'embase comme l'illustre clairement la Figure 3a et notamment sur une partie des anneaux de masse 107. Ainsi lors d'un dépôt conducteur ultérieur, il sera possible de reprendre le contact électrique au niveau des plots 107.

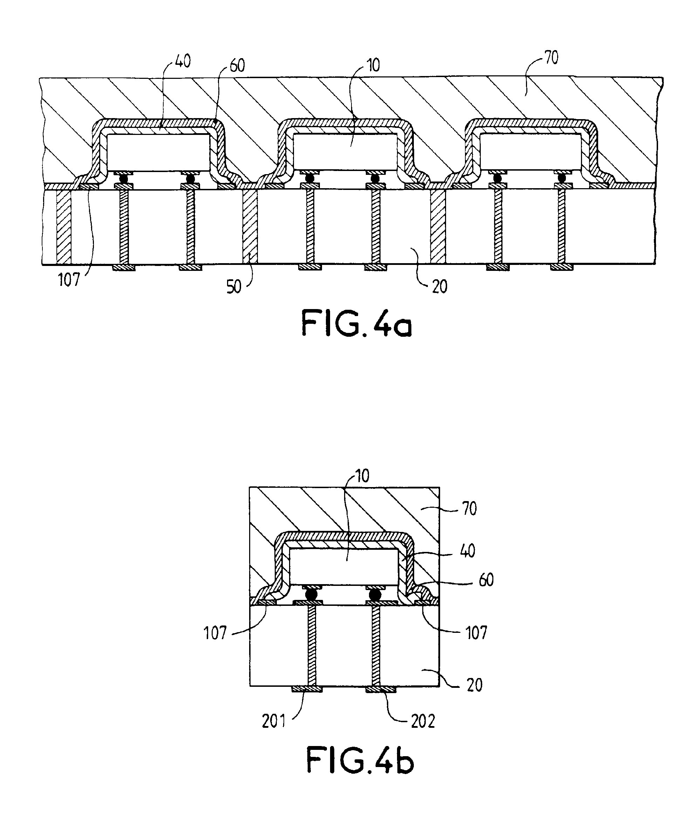

Le procédé selon l'invention comprend en outre une étape de protection finale réalisée par le coulage sur l'ensemble de la plaque, d'une résine d'encapsulation 70 pouvant être de type résine epoxy chargée de particules minérales au-dessus d'un dépôt conducteur 60 et du film déformable 40. Le film déformable préalablement déposé constitue alors une barrière empêchant ainsi à ladite résine d'encapsulation de pénétrer entre l'embase et les composants, comme illustré en Figure 4a.

De manière classique, les composants peuvent alors être testés électriquement sur la plaque, marqués individuellement, puis séparés par découpe mécanique à l'aide d'une scie, comme illustré en Figure 4b.

Le procédé d'encapsulation collective selon l'invention permet ainsi d'accéder à un degré d'intégration élevé en raison de la faible épaisseur du film déformable. De plus le film et la résine d'enrobage renforcent la tenue mécanique de l'assemblage ce qui rend ce procédé parfaitement compatible avec des composants à ondes acoustiques de grandes dimensions (ce qui n'est pas le cas de l'encapsulation en boîtier hermétique classique avec assemblage de type "flip-chip").

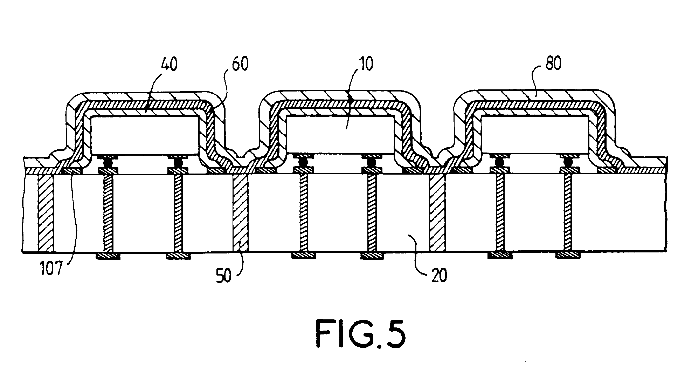

Selon une autre variante de l'invention, il est possible d'utiliser le dépôt d'un second film déformable pour assurer en remplacement d'une résine épaisse, la fonction de protection hermétique du ou des composants. La figure 5 illustre à ce titre une configuration dans laquelle un second film déformable 80 est déposé au-dessus de la couche conductrice 60, elle-même déposée à la surface du premier film déformable 40.

## Revendications

1. Procédé d'encapsulation de composant électronique caractérisé en ce qu'il comprend les étapes suivantes.
- Le report d'au moins un composant électronique (10) côté face active sur une embase (20), ladite embase comportant sur une première face des contacts électriques (101, 102, 107), sur une seconde face des plots de connexions (201, 202), et comportant une première série de vias (301, 302) reliant les contacts électriques et les plots de connexion et une série de trous (50).
- Le dépôt d'un film déformable (40) sur la face opposée à la face active du ou des composants électroniques.
- L'aspiration du film déformable, au travers de la série de trous (50) depuis la seconde face de l'embase, de manière à envelopper le ou lesdits composants électroniques, et mettre en contact avec le film déformable, ces derniers, de manière à former un assemblage solide.

2. Procédé d'encapsulation selon la revendication 1, caractérisé en ce que le ou les composants sont des dispositifs à ondes de surface.

3. Procédé d'encapsulation selon l'une des revendications 1 ou 2, caractérisé en ce que le report est effectué par l'intermédiaire de billes métalliques soudées (105, 106).

4. Procédé d'encapsulation selon l'une des revendications 1 à 3, caractérisé en ce qu'il comprend une étape de chauffage combinée à l'étape d'aspiration.

5. Procédé d'encapsulation selon l'une des revendications 1 à 4, caractérisé en ce que l'étape d'aspiration est effectuée avec l'application d'une pression à la surface dudit film.

6. Procédé d'encapsulation selon l'une des revendications 1 à 5, caractérisé en ce que le film déformable comporte un adhésif sur sa face en contact avec la face opposée à la face active du ou des composants électroniques.

7. Procédé d'encapsulation selon l'une des revendications 1 à 5, caractérisé en ce que le film déformable est un film thermoplastique.

8. Procédé d'encapsulation selon l'une des revendications 1 à 7, caractérisé en ce que le film déformable est un film conducteur.

9. Procédé d'encapsulation selon l'une des revendications 1 à 8, caractérisé en ce que le film déformable a une épaisseur de l'ordre de quelques dizaines de microns.

10. Procédé d'encapsulation selon l'une des revendications 1 à 9 caractérisé en ce qu'il comprend en outre un dépôt minéral sur le film déformable.

11. Procédé d'encapsulation selon l'une des revendications 1 à 10 caractérisé en ce qu'il comprend un dépôt conducteur pour assurer le blindage des composants (60).

12. Procédé d'encapsulation selon l'une des revendications 1 à 11 caractérisé en ce qu'il comprend une étape de découpe locale du film déformable au moins au niveau de certains plots de connexions de manière à assurer une reprise des contacts électriques.

13. Procédé d'encapsulation selon l'une des revendications 1 à 11, caractérisé en ce qu'il comprend le dépôt d'une résine épaisse d'encapsulation (70) sur le film souple de manière à assurer la protection hermétique du ou des composants électroniques.

14. Procédé d'encapsulation selon l'une des revendications 1 à 12, caractérisé en ce qu'il comprend le dépôt d'un second film déformable (80) sur le film souple de manière à assurer la protection hermétique du ou des composants électroniques.

15. Procédé d'encapsulation selon la revendication 14, caractérisé en ce que le second film souple (80) est un polymère chargé de particules minérales conductrices.

16. Procédé de fabrication collective de composants électroniques encapsulés comprenant les étapes suivantes :
- Le report collectif de composants électroniques (10) côté face active sur une embase (20), ladite embase comportant sur une première face des contacts électriques (101, 102, 107), sur une seconde face des plots de connexions (201, 202) une première série de vias (301, 302) reliant les contacts électriques et les plots de connexion et une seconde série de trous (50).
- Le dépôt d'un film déformable (40) sur l'ensemble des faces opposées aux faces actives des composants électroniques.
- L'aspiration du film déformable, au travers de la série de trous depuis la seconde face de l'embase, de manière à envelopper lesdits composants.
- Le dépôt d'une résine d'encapsulation (70) sur le film déformable de manière à assurer la protection hermétique des composants électroniques.
- La découpe de l'ensemble résine/film déformable/embase de manière à individualiser les composants électroniques encapsulés.
